# EUROPÄISCHE PATENTSCHRIFT

(11) **EP 1 743 049 B1**
(45) Veröffentlichungstag und Bekanntmachung des Hinweises auf die Patenterteilung: **23.03.2011**
(21) Anmeldenummer: 05736211.3
(22) Anmeldetag: 16.04.2005
(51) Int. Cl.: C23C 14/56, C23C 14/24

(54) **VORRICHTUNG UND VERFAHREN ZUR KONTINUIERLICHEN THERMISCHEN VAKUUMBESCHICHTUNG**
CONTINUOUS THERMAL VACUUM DEPOSITION DEVICE AND METHOD
DISPOSITIF ET PROCEDE DE DEPOT THERMIQUE CONTINU SOUS VIDE

(30) Priorität: 27.04.2004 DE 102004020841; 27.08.2004 DE 102004041855
(43) Veröffentlichungstag der Anmeldung: 17.01.2007
(73) Patentinhaber: VON ARDENNE ANLAGENTECHNIK GMBH, 01324 Dresden (DE)
(72) Erfinder: GOTTSMANN, Lutz, 01900 Kleinröhrsdorf (DE); SEYFERT, Ulf, 01324 Dresden (DE); WENZEL, Bernd-Dieter, 01909 Grosshartau (DE)
(74) Vertreter: Adler, Peter
(86) Internationale Anmeldenummer: PCT/DE2005/000700
(87) Internationale Veröffentlichungsnummer: WO 2005/106071

(56) Entgegenhaltungen:
- WO-A-97/47782
- BE-A3- 1 010 720
- US-B1- 6 202 591

## Beschreibung

Die Erfindung betrifft ein Beschichtungsverfahren zur thermischen Vakuumbeschichtung von einem kontinuierlich transportierten Substrat, das sich in einem Bedampfungskanal bewegt, durch Verdampfen von festen/oder flüssigen Beschichtungsmaterialien und Dampfabscheidung des dampfförmigen Beschichtungsmaterials auf dem Substrat in einer Bedampfungseinrichtung.

Ferner betrifft die Erfindung eine Beschichtungseinrichtung zur Vakuumbeschichtung von kontinuierlich transportiertem Substrat mit einer Bedampfungskammer, in der ein das Substrat umschließender Bedampfungskanal angeordnet ist, und einer mit dem Bedampfungskanal verbundenen Verdampfungseinrichtung.

Beschichtungsanlagen und Beschichtungsverfahren zur thermischen Dampfbeschichtung im Vakuum sind bekannt. Beispeilsweise offen bart die EP 0 735 157 ein Verfahren zum Verdampfen von Magnesium (Mg). Verfahrensgemäß wird eine Mg-Quelle in einem Gefäß mit einer engen Öffnung und mit einer außerhalb der Öffnung angeordneten Reflektorplatte bereitgestellt Das Gefäß wird auf eine Temperatur von 670 °C bis 770 °C erwärmt, wobei die Mg-Quelle geschmolzen wird und das Mg wird dabei verdampft. Beim Ausströmen werden Cluster und Spritzer an der Reflektorplatte bei 500 °C oder höher zerstört und der Mg-Dampf wird durch einen auf wenigstens 500 °C erwärmten Kanal von dem Auslass des Gefäßes zu einem am Kanalausgang positionierten Substratblatt geleitet. Zusätzlich wird der Mg-Dampf durch den Kanal von dem Auslass des Gefäßes zu einem Substratblatt transportiert.

BE 1010720 A offenbart eine Beschichtungsanlage zum Beschichten von bandförmigen Substraten mit einer Legierung, wobei die verschiedenen Legierungskomponenten außerhalb der Beschichtungskammer verdampft und gemischt werden.

Es wird allgemein unterschieden in Anlagen nach einem statischen oder einem kontinuierlichen Verfahren. Während beim statischen Verfahren die Substratzufuhr diskontinuierlich erfolgt und der regelmäßige Substratwechsel die regelmäßige Bevorratung mit neuem Beschichtungsmaterial für einen folgenden Beschichtungsprozess ermöglicht, wird beim kontinuierlichen Verfahren ein Substrat fortwährend durch die Beschichtungseinrichtung hindurch transportiert. Um den kontinuierlichen Prozess nicht zu unterbrechen und zur wirtschaftlichen Nutzung einer solchen Anlage besteht hierbei die Notwendigkeit der Bevorratung der Beschichtungseinrichtung mit Beschichtungsmaterial in einer Menge, die ausreichend ist, um zumindest eine Substrateinheit, beispielsweise eine Rolle ohne Unterbrechung zu beschichten.

Das Ausmaß der Verdampfungseinrichtung, d.h. Menge des verdampften Beschichtungsmaterials pro Zeiteinheit, ist direkt mit der Größe und der Fördergeschwindigkeit des Substrates verbunden; zudem erfordert eine hohe Dampfausnutzung eine umso größere, d.h. höhere, Bedampfungskammer. Insofern steht die Wirtschaftlichkeit in einem direkten Zusammenhang mit der Anlagengröße und somit auch mit der Größe der Verdampfungseinrichtung, wodurch den beschriebenen kontinuierlichen Beschichtungsanlagen wegen der Bevorratung des Beschichtungsmaterials und der damit einhergehenden Wirtschaftlichkeit Grenzen gesetzt sind.

In Anlagen mit kontinuierlichem Substrattransport wurde bislang wegen der geringeren Substratabmessungen und der damit verbundenen einfacheren Beherrschbarkeit als zweckmäßig erachtet, die Verdampfungseinrichtung in der Bedampfungskammer anzuordnen. Die Nachteile einer solchen Anordnung sind jedoch speziell bei größeren Substratabmessungen vielfältig. Auf Grund der räumlich anspruchsvollen Ausmaße der Verdampfungseinrichtung hat eine wirtschaftlich vorteilhafte Anlage erhebliche Ausmaße hinsichtlich der Ausdehnung in der Ebene.

Insbesondere ist auch eine voneinander unabhängige Prozesssteuerung von Bedampfungskanal und Verdampfungseinrichtung aufgrund dieser räumlichen Nähe zueinander nicht ausreichend gut möglich. Eine Wartung an der Verdampfungseinrichtung bewirkt zwangsläufig einen Anlagenstillstand und ist zudem umständlich, da die Verdampfungseinrichtung als Intergralbauteil nur schwer zugänglich ist. Ferner ist eine Veränderung der Verdampfungseinrichtung durch Modifizierung von Bauteilen oder eine Erweiterung mit weiteren Modulen nicht möglich. Auch ist eine kontinuierliche Bereitstellung von Beschichtungsmaterial, was insbesondere bei der Beschichtung von kontinuierlich transportiertem Substrat erforderlich ist, nur mit erheblichem Aufwand möglich.

Daher ist es Aufgabe der vorliegenden Erfindung, ein solches Beschichtungsverfahren und eine Beschichtungseinrichtung zur thermischen Vakuumbeschichtung von kontinuierlich transportiertem Substrat bereitzustellen bei dem die Zugänglichkeit zu der Verdampfungseinrichtung verbessert wird und gleichzeitig eine voneinander unabhängige Prozesssteuerung von Bedampfungskammer und Verdampfungseinrichtung möglich ist.

Die Aufgabe wird durch ein Verfahren gemäß Anspruch 1 und eine Einrichtung gemäß Anspruch 9 gelöst. Das Beschichtungsmaterial wird in wenigstens einer außerhalb der Bedampfungskammer angeordneten Verdampfungseinrichtung mit einem Verdampfer verdampft, wobei die Dampfzufuhr zwischen Verdampfer und Bedampfungskanal reguliert wird.

Von der Erfindung ist jede geeignete, zumindest dampfdichte Regulierungsmöglichkeit erfasst. So ist wegen der Beschränkung auf dampfdichte Regulierungsfunktion beispielsweise auch eine einfache Verschlussplatte einsetzbar, wobei in diesem Fall die Regulierung auf die beiden Zustände offen und geschlossen begrenzt ist.

Die Anordnung der Verdampfungseinrichtung außerhalb der Bedampfungskammer ermöglicht im Zusammenhang mit der erfindungsgemäßen Regulierungsmöglichkeit, die auch die vollkommene Schließung der Dampfaustrittsöffnung impliziert, einen Zugriff auf den Verdampfer bei gleichzeitiger Aufrechterhaltung der Prozessbedingungen im Bedampfungskanal. Somit kann das Substrat im Bedampfungskanal verbleiben während der Verdampfer beispielsweise mit neuem Beschichtungsmaterial bestückt wird.

Des Weiteren gestattet diese räumlich getrennte Anordnung von Verdampfungseinrichtung und Bedampfungskammer auch eine getrennte Prozesssteuerung insbesondere hinsichtlich der Vakuumverhältnisse und des Temperaturregimes, da infolge dessen auch die einzelnen Regelstrecken der Prozessbedingungen räumlich getrennt oder zumindest wahlweise räumlich getrennt ausführbar sind. Insbesondere die dampfdichte Regulierung der Verbindung zwischen den beiden Hauptbestandteilen der Beschichtungsanlage und deren dadurch möglichen getrennten Öffnung erfordert auch eine getrennte Steuerung der Vakuumbedingungen.

Zweckmäßigerweise erfolgt die Regulierung der Dampfzufuhr, entsprechend einer besonders günstigen Ausgestaltung der Erfindung, über ein austrittsseitig an dem Verdampfer angeordnetes Dampfsperr-Ventil. Die Regulierung betrifft hierbei sowohl die Schaltung zwischen Durchlass und keinem Durchlass als auch eine Dosierung der Dampfmenge. Eine Dosierung der Verdampfungsmenge kann darüber hinaus auch durch die Regulierung des Prozessdruckes und der Temperatur erfolgen.

In einer Ausführungsform ist vorgesehen, dass das dampfförmige Beschichtungsmaterial aus dem Verdampfer in eine Dampfsammeleinrichtung der Verdampfungseinrichtung geleitet wird.

Insbesondere im Fall von mehreren, d.h. drei, vier, fünf oder mehr Verdampfern je Verdampfungseinrichtung ist es für eine gleichmäßige Dampfdosierung vorteilhaft, das dampfförmige Beschichtungsmaterial aus den jeweiligen, in Betrieb befindlichen Verdampfungskammern zu vereinigen und aus diesem gemeinsamen Volumen in die Bedampfungskammer einzuleiten. Auf diese Weise können bei hinreichend groß bemessenem Volumen der Dampfsammeleinrichtung insbesondere Schwankungen in der Dampfzufuhr oder gar Unterbrechungen wegen Neubeschickung ausgeglichen werden. Dazu wird die Dampfsammeleinrichtung ebenfalls evakuiert und zusätzlich geheizt, damit sich das dampfförmige Beschichtungsmaterial nicht an den Wänden abscheiden kann.

Vorteilhafterweise ist vorgesehen, dass zur kontinuierlichen Beschickung das dampfförmige Beschichtungsmaterial von dem Verdampfer zu dem Bedampfungskanal transportiert wird; und dass zur Beschickung mit dem festen und/oder flüssigen Beschichtungsmaterial die Dampfzufuhr zwischen dem Verdampfer und dem Bedampfungskanal unterbunden wird.

Es ist dabei besonders zweckmäßig, dass mindestens zwei Verdampfer angeordnet werden und deren Dampfsperr-Ventile unabhängig voneinander angesteuert werden.

Im Falle von mehreren Verdampfern wird damit eine abgestufte Dosierung durch die Anzahl der geöffneten und somit in Verdampfungsbetrieb befindlichen Verdampfer erreicht, was neben der besonders gleichmäßigen, vom aktuellen Betriebszustand einzelner Verdampfer relativ unabhängigen Dampfversorgung des Bedampfungskanals auch die Berücksichtigung spezieller Substratanordnungen oder besonderer Beschichtungsprofile ermöglicht.

Das bandförmige Substrat erstreckt sich im Betriebszustand im Regelfall jedoch im Wesentlichen symmetrisch durch den Bedampfungskanal. Zur kontinuierlichen Beschickung des Bedampfungskanals muss dann, entsprechend einer besonders vorteilhaften Ausführungsform wechselweise zumindest ein Verdampfer in Betrieb sein und in Dampfzufuhr mit dem Bedampfungskanal stehen, während zur Beschickung mit dem neuen Beschichtungsmaterial die Dampfzufuhr des zu beschickenden verdampfers unterbunden wird. Somit ergibt sich ein wirtschaftlich vorteilhafter permanent kontinuierlicher Bedampfungsprozess.

Für höhere Beschichtungsflächen pro Zeiteinheit werden in einer weiteren Ausgestaltung der Erfindung zur kontinuierlichen Beschickung des Bedampfungskanals vier Verdampfer angeordnet, von denen abwechselnd immer drei mit dem dampfförmigen Beschichtungsmaterial in Dampfzufuhr mit dem Bedampfungskanal stehen und zur Beschickung mit dem festem und/oder flüssigen Beschichtungsmaterial die Dampfzufuhr des zu beschickenden Verdampfers unterbunden wird. In diesem Fall ist die Bereitstellung selbst größerer Mengen an dampfförmigem Beschichtungsmaterial dadurch gewährleistet, dass sämtliche Verdampfern in Betrieb sind und wechselweise immer nur einer mit neuem Beschichtungsmaterial beschickt wird.

Eine Anordnung von vier oder mehr Verdampfern in einer Verdampfungseinrichtung bietet außerdem eine hohe Flexibilität in der Nutzung sowie die Möglichkeit einer Erweiterung mit weiteren Verdampfermodulen.

In einer ganz besonders vorteilhaften Ausführungsform erfolgt die Beschickung des Bedampfungskanals mit dem dampfförmigen Beschichtungsmaterial über zwei Verdampfungseinrichtungen. Der Bedampfungskanal wird dabei von zwei, vorzugsweise gegenüberliegenden Seiten mit dem dampfförmigen Beschichtungsmaterial gespeist. Der Eintritt des Beschichtungsmaterials aus unterschiedlichen Richtungen bewirkt eine optimierte Verteilung im Bedampfungskanal.

In einer anderen weitergehenden Ausführungsform der Erfindung erfolgt die Beschickung des Bedampfungskanals mit dem dampfförmigen Beschichtungsmaterial über eine zwischen dem Bedampfungskanal und der Verdampfungseinrichtung angeordneten Dampftransportlinie. Die Bemessung der Transportlinie zur Gewährleistung einer gleichmäßigen und ausreichenden zufuhr an dampfförmigem Beschichtungsmaterial erfolgt dabei entsprechend dem dafür erforderlichen Durchsatz durch die Transportlinie zum Bedampfungskanal, welcher einerseits durch die Menge des in der Verdampfungseinrichtung verdampften und verdampfungsseitig in die Transportlinie eintretenden Beschichtungsmaterials und andererseits durch die Menge des am anderen Ende der Transportlinie in den Bedampfungskanal eintretenden und auf dem Substrat kondensierten und somit volumenverringerten Beschichtungsmaterials vorgegeben wird. Dabei wird die Kondensatmenge durch Breite und Transportgeschwindigkeit des Substrats sowie durch die physikalischen Prozessparameter definiert.

Anordnungsseitig wird die der Erfindung zugrunde liegende Aufgabenstellung gelöst, indem die Verdampfungseinrichtung von der Bedampfungskammer beabstandet angeordnet ist. Diese räumliche Trennung ermöglicht eine optimale bauliche Trennung der beiden Hauptbestandteile der Anlage und deren Gestalten in modularer Bauweise. Dies ermöglicht insbesondere bei mehreren Verdampfern, entsprechend einer weiteren Ausgestaltung der Erfindung, deren räumliche Ausgliederung, so dass die erforderliche, zusammenhängende Grundfläche für das Kernbauteil der Beschichtungseinrichtung, nämlich der Bedampfungskammer, im wesentlichen auf die für die Bedampfung erforderliche Größe der Bedampfungskammer zusammenschrumpft. Die Verdampfungseinrichtung wird dabei von der Bedampfungskammer beabstandet und gegebenenfalls satellitenartig an anderen Orten mit verfügbarem Freiraum platziert errichtet und, entsprechend einer besonders günstigen Ausgestaltung der Erfindung mittels einer oder mehrerer Dampftransportlinien mit der Bedampfungskammer verbunden.

Die Dampftransportlinie oder Transportlinien werden zur Minimierung der Materialverluste und Gewährleistung reproduzierbarer Beschichtungsbedingungen, wie auch die Dampfsammeleinrichtung und die Bedampfungskammer, im Vakuum betrieben und geheizt, wobei die Heizung besonders bevorzugt vollumfänglich erfolgt. Durch eine ausreichend hohe Temperatur der geheizten Innenwand wird dort auftreffender Dampf im laufenden Prozess reverdampft, wobei dieser Effekt umso stärker ist, je höher die Temperatur der Innenwand ist. Die Dampftransportlinie ist dampfdicht zwischen Bedampfungskanal und Verdampfungseinrichtung fixiert. Umfasst die Verdampfungseinrichtung entsprechend einer anderen vorteilhaften Ausführungsform eine Dampfsammeleinrichtung, schließt die Dampftransportlinie dort an. Damit sind die oben beschriebenen, verschiedenen Zusammenschlüsse oder wechselweise Zuschaltungen mehrerer Verdampfer auch über räumliche Abstände hinweg realisierbar.

Die Dampfsammeleinrichtung ist dafür zentral zwischen den Verdampfern angeordnet und mit diesen einerseits und zumindest mittelbar mit der Bedampfungseinrichtung andererseits verbunden. Die Dampfsammeleinrichtung ist beheizbar, vorzugsweise vollumfänglich, und/oder evakuierbar.

Eine Anordnung von mehreren z.B. vier Verdampfern in einer Verdampfungseinrichtung bietet eine hohe Flexibilität in der Nutzung und mit drei aktiven, d.h. in Betrieb befindlichen, Verdampfern eine große Menge dampfförmigen Beschichtungsmaterials. Zu jeder Seite der länglich ausgebildeten Dampfsammeleinrichtung stehen sich jeweils zwei Verdampfungskammern direkt gegenüber. Die Verdampfungskammern erstrecken sich vorteilhafter Weise quer zu der länglichen Dampfsammeleinrichtung. Zweckmäßig ist, dass die Dampfsammeleinrichtung und die Verdampfer über Damfsperr-Ventile miteinander verbunden sind.

Die Erfindung soll nachfolgend anhand eines Ausführungsbeispiels näher erläutert werden. In der zugehörigen Zeichnung zeigt die Zeichnungsfigur einen Ausschnitt eines horizontalen Querschnitts durch eine erfindungsgemäße Beschichtungseinrichtung mit einer externen Verdampfungseinrichtung.

Zum Gegenstand:
Die Zeichnungsfigur zeigt eine erfindungsgemäße Beschichtungseinrichtung 1 mit einer Bedampfungskammer 2 und einer davon beabstandete externen Verdampfungseinrichtung 3. Die Bedampfungskammer 2 ist mit den Verdampfungseinrichtungen 3 jeweils über eine Dampftransportlinie 4 verbunden, wobei die Verdampfungseinrichtung 3 an der Dampftransportlinie 4 angeordnet ist.

Die Verdampfungseinrichtung 3 besteht aus einer kanalartig ausgebildeten zentralen Dampfsammeleinrichtung 5 und vier Verdampfern 6. Die Verdampfer 6 erstrecken sich lateral von der Dampfsammeleinrichtung 5 und sind paarweise gegenüberliegend in einer Ebene an der Dampfsammeleinrichtung 5 angeordnet.

Jede Verdampfungskammer 8 umfasst einen durch eine umgebende elektrische Heizeinrichtung 7 beheizbaren Verdampfer 6. Innerhalb der Verdampfungskammer 8 und des Verdampfer 6 herrscht Prozessvakuum.

In dem Verdampfer ist ein Tiegel 9 mit festem Beschichtungsmaterial 10, beispielsweise Magnesium, angeordnet. Der Verdampfer 6 ist über ein steuerbares Dampfsperr-Ventil 11 mit der Dampfsammeleinrichtung 5 verbunden.

Die Dampfsammeleinrichtung 5 ist als röhrenartiger Kanal ausgebildet und mit einer elektrischen Heizeinrichtung 7 vollumfänglich ummantelt. Das bedampfungskammerseitige Ende der Dampftransportlinie 4 mündet im Bedampfungskanal 13 und ist als Düse 12 ausgebildet.

Die Düse 12 tritt an einer Seite in den als innen hohler Quader ausgebauten Bedampfungskanal 13 ein. In dem Bedampfungskanal 13 wird in Betriebsstellung symmetrisch ein bandförmiges Substrat 14 transportiert, welches symmetrisch in dem hohlen, quaderförmigen Bedampfungskanal 13 angeordnet ist. Die Düse 12 tritt mittig in den Bedampfungskanal 13 ein. Um den Bedampfungskanal 13 ist vollumfänglich eine Heizeinrichtung 7 angebracht.

Somit verfügt die erfindungsgemäße Beschichtungseinrichtung 1 über eine vollständig geschlossene Vakuumkammer von der 3 Verdampfungskammer 8 über die Dampftransportlinie 4 bis zu der Bedampfungskammer 2.

Zum Verfahren:
Das Beschichtungsverfahren ist ein kontinuierliche thermische Vakuumbeschichtung des bandförmigen Substrats 14 durch Verdampfen von festem Magnesium als Beschichtungsmaterial 10 und Dampfabscheidung des dampfförmigen Beschichtungsmaterials 10 auf dem kontinuierlich transportierten Substrat 14 Bedampfungskanal 13.

Jede Verdampfungskammer 8 mit dem festen Beschichtungsmaterial 10 wird evakuiert und der Verdampfer 6 ausreichend erhitzt. Wenn das Beschichtungsmaterial 10 verdampft wird, öffnet das Dampfsperr-Ventil 11 und gibt den Zugang in die Dampfsammeleinrichtung 5 frei. Durch die Volumenzunahme beim Übergang vom festen in den dampfförmigen Zustand des Beschichtungsmaterials 10 drängt fortwährend weiteres dampfförmiges Beschichtungsmaterial 10 nach und gibt die Transportrichtung vor.

Im Verdampfungsprozess sind jeweils immer drei der vier Verdampfer 6 in Betrieb, d.h. die Dampfsperr-Ventile 11 sind geöffnet und festes Beschichtungsmaterial 10 wird zu dampfförmigem verdampft. Der jeweils vierte Verdampfer 6 ist außer Betrieb, und der Tiegel 9 wird mit weiterem festen Beschichtungsmaterial 10 beschickt, danach wird der 8 Verdampfer 6 evakuiert und aufgeheizt. Ist dieser Verdampfer 6 betriebsbereit, wird das Dampfsperr-Ventil 11 geöffnet und ein anderer der drei Verdampfer 6 außer Betrieb gesetzt und beschickt. Der Wechselzyklus variiert.

Das aus den in Betrieb befindlichen Verdampfern 6 einer verdampfungseinrichtung 3 durch die Dampfsperr-Ventile in den ebenfalls geheizten Dampfsammelraum 5 gelangte dampfförmige Beschichtungsmaterial 10 strömt durch die ausreichend geheizte Dampftransportlinie 4 und wird durch die ebenfalls ausreichend geheizte Düse 12 hindurch beschleunigt und in den Bedämpfungskanal 13 befördert. Durch die in Abhängigkeit von dem Beschichtungsmaterial 10 geeignet gewählte Heiztemperatur und damit Oberflächentemperatur von Verdampfer 6, Dampfsammeleinrichtung 5, Dampftransportlinie 4, Düse 12 und Bedampfungskanal 13 wird das auf die Innenwände treffende dampfförmige Beschichtungsmaterial 10 reverdampft, so dass eine Abscheidung von festem Beschichtungsmaterial 10 an den Innenwänden unterbunden wird.

Das in den ausreichend geheizten und ebenfalls evakuierten Bedampfungskanal 13 gelangte dampfförmige Beschichtungsmaterial 10 scheidet sich auf dem kalten, durch den Bedampfungskanal 13 transportierten bandförmigen Substrat 14 ab.

Durch das erfindungsgemäße Beschichtungsverfahren wird ein vollständig kontinuierlicher Prozess mit einem extrem hohen Dampfausnutzungsgrad bereitgestellt.

Vorrichtung und Verfahren zur kontinuierlichen thermische Vakuumbeschichtung

### Bezugszeichenliste

- 1: Beschichtungseinrichtung
- 2: Bedampfungskammer
- 3: Verdampfungseinrichtung
- 4: Dampftransportlinie
- 5: Dampfsammeleinrichtung
- 6: Verdampfer
- 7: Heizeinrichtung
- 8: Verdampfungskammer
- 9: Tiegel
- 10: Beschichtungsmaterial
- 11: Dampfsperr-Ventil
- 12: Düse
- 13: Bedampfungskanal
- 14: Substrat

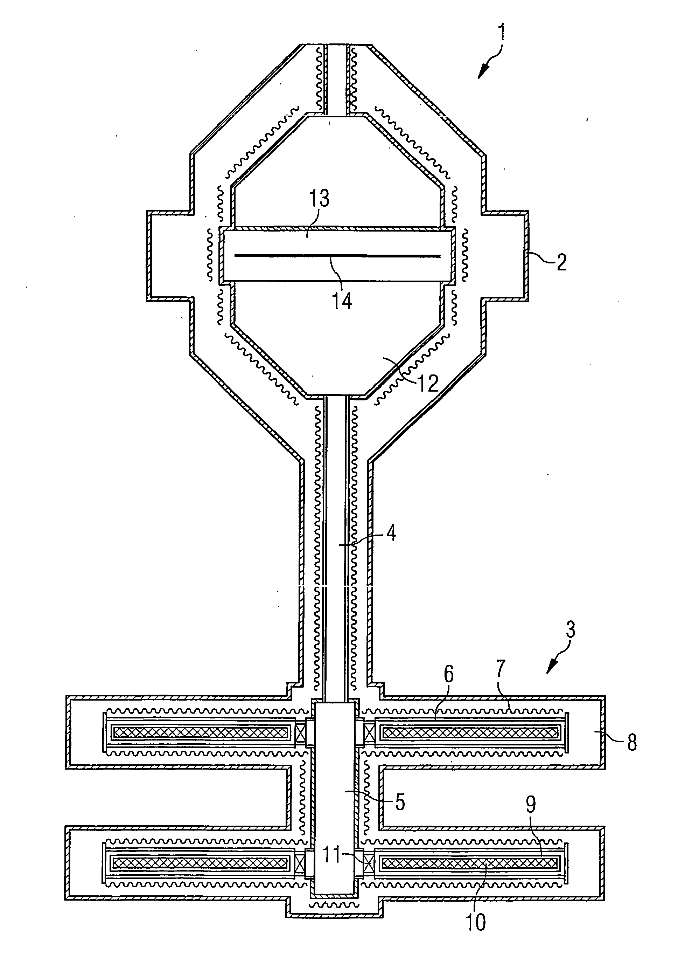

## Patentansprüche

1. Beschichtungsverfahren zur thermischen Vakuumbeschichtung von einem kontinuierlich transportierten Substrat, das sich in einem Bedampfungskanal bewegt, durch Verdampfen von festen und/oder flüssigen Beschichtungsmaterialen und Dampfabscheidung des dampfförmigen Beschichtungsmaterials auf dem Substrat in einer Bedampfungseinrichtung, wobei das Beschichtungsmaterial (10) in wenigstens einer außerhalb der Bedampfungskammer (2) angeordneten Verdampfungseinrichtung (3) mit mindestens zwei Verdampfern (6) pro Verdampfungseinrichtung verdampft wird und die Dampfzufuhr zwischen dem Verdampfer (6) und dem Bedampfungskanal (13) reguliert wird, **dadurch gekennzeichnet, dass** zur kontinuierlichen Beschickung der Bedampfungskammer (2) mit dem dampfförmigen Beschichtungsmaterial die Verdampfer (6) abwechselnd Dampf zum Bedampfungskanal (13) zuführen und zur Beschickung mit dem festen und/oder flüssigen Beschichtungsmaterial (10) die Dampfzufuhr des zu beschickenden Verdampfers (6) unterbunden wird.

2. Beschichtungsverfahren nach Anspruch 1, **dadurch gekennzeichnet, dass** die Regulierung über austrittsseitig an den Verdampfern (6) angeordnete Dampfsperr-Ventile (11) erfolgt.

3. Beschichtungsverfahren nach Anspruch 1 oder 2 , **dadurch gekennzeichnet, dass** das dampfförmige Beschichtungsmaterial aus dem Verdampfer (6) in eine Dampfsammeleinrichtung (5) der Verdampfungseinrichtung (3) geleitet wird.

4. Beschichtungsverfahren nach einem der Ansprüche 1 bis 3, **dadurch gekennzeichnet, dass** zur kontinuierlichen Beschickung das dampfförmige Beschichtungsmaterial (10) von dem Verdampfer (6) zu dem Bedampfungskanal (13) transportiert wird, und dass zur Beschickung mit dem festen und/oder flüssigen Beschichtungsmaterial (10) die Dampfzufuhr zwischen dem Verdampfer (6) und dem Bedampfungskanal (13) unterbunden wird.

5. Beschichtungsverfahren einem der Ansprüche 1 bis 4, **dadurch gekennzeichnet, dass** die Dampfsperr-Ventile (11) unabhängig voneinander angesteuert werden.

6. Beschichtungsverfahren nach Anspruch 5, **dadurch gekennzeichnet, dass** zur kontinuierlichen Beschickung der Bedampfungseinrichtung (1) vier Verdampfer (6) angeordnet werden und mit dem dampfförmigen Beschichtungsmaterial abwechselnd immer drei von vier Verdampfern (6) in Dampfzufuhr mit dem Bedampfungskanal (13) stehen und zur Beschickung mit dem festen und/oder flüssigen Beschichtungsmaterial (10) die Dampfzufuhr des zu beschickenden Verdampfers (6) unterbunden wird.

7. Beschichtungsverfahren nach einem der Ansprüche 1 bis 6, **dadurch gekennzeichnet, dass** die Beschickung des Bedampfungskanals (13) mit dem dampfförmigen Beschichtungsmaterial (10) über eine zwischen dem Bedampfungskanal (13) und der Verdampfungseinrichtung (3) angeordneten Dampftransportlinie (4) erfolgt.

8. Beschichtungsverfahren nach einem der Ansprüche 1 bis 7, **dadurch gekennzeichnet, dass** die Beschickung des Bedampfungskanals (13) mit dem dampfförmigen Beschichtungsmaterial über zwei Verdampfungseinrichtungen (3) erfolgt.

9. Beschichtungseinrichtung zur thermischen Vakuumbeschichtung von kontinuierlich transportiertem Substrat mit einer Bedampfungskammer, in der ein das Substrat umschließender Bedampfungskanal angeordnet ist, und einer mit dem Bedampfungskanal verbundenen Verdampfungseinrichtung, wobei die Verdampfungseinrichtung (3) von der Bedampfungskammer (2) beabstandet angeordnet ist, die Verdampfungseinrichtung (3) mindestens zwei Verdampfer (6) aufweist, die mit dem Bedampfungskanal (13) über eine beheizte Dampftransportlinie (4) verbunden ist und die Verdampfungseinrichtung (3) eine Dampfsammeleinrichtung (5) umfasst, **dadurch gekennzeichnet, dass** die Dampfsammeleinrichtung (5) und die Verdampfer (6) über je ein Dampfsperr-Ventil (11) miteinander verbunden sind.

## Claims

1. Coating method for the thermal vacuum coating of a continuously transported substrate, which is moved in a vapour-depositing channel, by vaporizing solid and/or liquid coating materials and vapour-depositing the vaporous coating material on the substrate in a vapour-depositing device, the coating material (10) being vaporized in at least one vaporizing device (3) arranged outside the vapour-depositing chamber (2), with at least two vaporizers (6) per vaporizing device, and the vapour supply between the vaporizer (6) and the vapour-depositing channel (13) being regulated, **characterized in that**, for continuously charging the vapour-depositing chamber (2) with the vaporous coating material, the vaporizers (6) alternately supply vapour to the vapour-depositing channel (13) and, for charging with the solid and/or liquid coating material (10), the vapour supply of the vaporizer (6) to be charged is interrupted.

2. Coating method according to Claim 1, **characterized in that** the regulating is performed by means of vapour shut-off valves (11) arranged on the outlet side of the vaporizers (6).

3. Coating method according to Claim 1 or 2, **characterized in that** the vaporous coating material is directed out of the vaporizer (6) into a vapour collecting device (5) of the vaporizing device (3).

4. Coating method according to one of Claims 1 to 3, **characterized in that**, for continuous charging, the vaporous coating material (10) is transported from the vaporizer (6) to the vapour-depositing channel (13), and **in that**, for charging with the solid and/or liquid coating material (10), the vapour supply between the vaporizer (6) and the vapour-depositing channel (13) is interrupted.

5. Coating method according to one of Claims 1 to 4, **characterized in that** the vapour shut-off valves (11) are activated independently of one another.

6. Coating method according to Claim 5, **characterized in that**, for the continuous charging of the vapour-depositing device (1), four vaporizers (6) are arranged and three out of four vaporizers (6) are always in vapour-supplying communication with the vapour-depositing channel (13) for providing it with the vaporous coating material and, for charging with the solid and/or liquid coating material (10), the vapour supply of the vaporizer (6) to be charged is interrupted.

7. Coating method according to one of Claims 1 to 6, **characterized in that** the charging of the vapour-depositing channel (13) with the vaporous coating material (10) is performed by means of a vapour transport line (4) arranged between the vapour-depositing channel (13) and the vaporizing device (3).

8. Coating method according to one of Claims 1 to 7, **characterized in that** the charging of the vapour-depositing channel (13) with the vaporous coating material is performed by means of two vaporizing devices (3).

9. Coating device for the thermal vacuum coating of a continuously transported substrate, with a vapour-depositing chamber, in which a vapour-depositing channel enclosing the substrate is arranged, and a vaporizing device connected to the vapour-depositing channel, the vaporizing device (3) being arranged at a distance from the vapour-depositing chamber (2), the vaporizing device (3) having at least two vaporizers (6), which are connected to the vapour-depositing channel (13) by means of a heated vapour transport line (4), and the vaporizing device (3) comprising a vapour-collecting device (5), **characterized in that** the vapour-collecting device (5) and the vaporizers (6) are connected to one another in each case by means of a vapour shut-off valve (11).

## Revendications

1. Procédé de revêtement thermique sous vide d'un substrat transporté en continu et qui se déplace dans un canal de dépôt de vapeur, par vaporisation de matériaux solides et/ou liquides de revêtement et dépôt de vapeur du matériau de revêtement sur le substrat dans un dispositif de dépôt de vapeur,
le matériau de revêtement (10) étant vaporisé dans au moins un dispositif de vaporisation (3) disposé à l'extérieur de la chambre de dépôt de vapeur (2) et présentant au moins deux vaporisateurs (6) par dispositif de vaporisation, l'apport de vapeur entre le vaporisateur (6) et le canal de dépôt de vapeur (13) étant régulé,
**caractérisé en ce que**,
pour assurer une alimentation continue de la chambre de dépôt de vapeur (2) en matériau de revêtement vaporisé, les évaporateurs (6) apportent de la vapeur en alternance dans le canal de dépôt de vapeur (13) et
**en ce que**, pour assurer l'alimentation en matériau solide et/ou en matériau liquide de revêtement (10), l'apport de vapeur par le vaporisateur (6) à alimenter est interrompu.

2. Procédé de revêtement selon la revendication 1, **caractérisé en ce que** la régulation s'effectue par des soupapes (11) de blocage de vapeur disposées à la sortie des évaporateurs (6).

3. Procédé de revêtement selon la revendication 1 ou 2, **caractérisé en ce que** le matériau de revêtement vaporisé provenant du vaporisateur (6) est introduit dans un dispositif (5) de collecte de vapeur du dispositif de vaporisation (3).

4. Procédé de revêtement selon l'une des revendications 1 à 3, **caractérisé en ce que**, pour assurer l'alimentation en continu, le matériau de revêtement (10) vaporisé est transporté depuis le vaporisateur (6) jusque dans le canal de dépôt de vapeur (13) et **en ce que**, pour assurer l'alimentation en matériau solide et/ou liquide de revêtement (10), l'apport de vapeur entre le vaporisateur (6) et le canal de dépôt de vapeur (13) est interrompu.

5. Procédé de revêtement selon l'une des revendications 1 à 4, **caractérisé en ce que** les soupapes (11) de blocage de vapeur sont commandées indépendamment les unes des autres.

6. Procédé de revêtement selon la revendication 5, **caractérisé en ce que**, pour assurer l'alimentation en continu du dispositif de vaporisation (1) en matériau de revêtement vaporisé, quatre évaporateurs (6) sont prévus, **en ce que** trois des quatre vaporisateurs (6) apportent en alternance de la vapeur dans le canal de dépôt de vapeur (13) et **en ce que**, pour l'alimentation en matériau solide et/ou en matériau liquide de revêtement (10), l'apport de vapeur par le vaporisateur (6) à alimenter est interrompu.

7. Procédé de revêtement selon l'une des revendications 1 à 6, **caractérisé en ce que** l'alimentation du canal de dépôt de vapeur (13) en matériau de revêtement vaporisé (10) s'effectue par l'intermédiaire d'une ligne (4) de transport de vapeur prévue entre le canal de dépôt de vapeur (13) et le dispositif de vaporisation (3).

8. Procédé de revêtement selon l'une des revendications 1 à 7, **caractérisé en ce que** l'alimentation du canal de dépôt de vapeur (13) en matériau de revêtement vaporisé s'effectue par l'intermédiaire de deux dispositifs de vaporisation (3).

9. Dispositif de revêtement thermique sous vide de substrat transporté en continu, présentant
une chambre de dépôt de vapeur dans laquelle est disposé un canal de dépôt de vapeur qui entoure le substrat et
un dispositif de vaporisation relié au canal de dépôt de vapeur,
le dispositif de vaporisation (3) étant disposé à distance de la chambre de dépôt de vapeur (2),
le dispositif de vaporisation (3) présentant au moins deux vaporisateurs (6) qui sont reliés au canal de dépôt de vapeur (13) par une ligne (4) chauffée de transport de vapeur, et
le dispositif de vaporisation (3) comprenant un dispositif (5) de collecte de vapeur,
**caractérisé en ce que**
le dispositif (5) de collecte de vapeur et les vaporisateurs (6) sont reliés les uns aux autres par des soupapes respectives (11) de blocage de vapeur.
